# EUROPÄISCHE PATENTANMELDUNG

(11) **EP 3 859 805 A1**
(43) Veröffentlichungstag der Anmeldung: **04.08.2021**
(21) Anmeldenummer: 20154798.1
(22) Anmeldetag: 31.01.2020
(51) Int. Cl.: H01L 51/44, B01D 53/26, H01G 9/26

(54) **ENTFEUCHTUNG EINES PHOTOVOLTAIKMODULS DURCH ELEKTROLYSE**

(71) Anmelder: Siemens Aktiengesellschaft, 80333 München (DE)
(72) Erfinder: Fleischer, Maximilian, 85635 Höhenkirchen (DE); Pohle, Roland, 85570 Herdweg (DE); Simon, Elfriede, 80639 München (DE); von Sicard, Oliver, 81541 München (DE)

(57) **Zusammenfassung**

Die Erfindung betrifft ein Photovoltaikmodul (1) umfassend mindestens eine Solarzelle (10), wobei die Solarzelle (10) von einer Verkapselungsvorrichtung (20) umschlossen ist, und eine Elektrolyseeinheit (30) zur Entfeuchtung des Inneren der Verkapselungsvorrichtung (20). Die Elektrolyseeinheit (30) weist eine Kathode (31), eine Anode (32) und einen die Kathode (31) und Anode (32) verbindenden Ionenleiter (33) auf. Die Elektrolyseeinheit (30) ist dafür ausgestaltet, Wasser in Wasserstoff und Sauerstoff aufzuspalten.

Die Erfindung betrifft ferner ein Verfahren zur Entfeuchtung eines Photovoltaikmoduls (1) mittels einer Elektrolyseeinheit (30) .

## Beschreibung

### Technisches Gebiet

Die Erfindung betrifft ein Verfahren zur Entfeuchtung eines Photovoltaikmoduls sowie ein Photovoltaikmodul mit einer solchen Vorrichtung.

### Stand der Technik

Seit einigen Jahren werden Perowskite, wie z.B. CH₃NH₃PbI₃, hinsichtlich ihrer Verwendbarkeit in Solarzellen untersucht. Aufgrund ihrer optoelektronischen Eigenschaften erlauben sie im Prinzip eine hocheffiziente Umwandlung von elektromagnetischer Strahlungsenergie in elektrische Energie. Perowskitbasierte Solarzellen, im Folgenden auch als Perowskit-Solarzellen bezeichnet, zeichnen sich zum einen dadurch aus, dass sie vergleichsweise kostengünstig in der Herstellung sind. Zum anderen stellen Perowskit-Solarzellen eine attraktive und ernstzunehmende Alternative zu herkömmlichen siliziumbasierten Solarzellen dar, weil sich aufgrund der in den letzten Jahren rasant erzielten Fortschritte hinsichtlich ihres Wirkungsgrades von einigen wenigen Prozent auf heutzutage über 25% andeutet, dass Wirkungsgrade erreichbar sind, die diejenigen herkömmlicher Silicium-Solarzellen signifikant übertreffen. Dabei ist es denkbar, eine Perowskit-Solarzelle allein oder aber in einem Tandem-Photovoltaik-Modul bspw. in Kombination mit einer kristallinen Silicium-Solarzelle zu betreiben.

Ein Nachteil des Perowskit-Materials im Vergleich zu Silicium ist seine hohe Feuchteempfindlichkeit. Selbst geringe Mengen an Feuchtigkeit können zu gravierenden Schäden an Perowskit-Solarzellen führen, die letztendlich zu einer oftmals irreversiblen Reduzierung des Wirkungsgrads der Perowskit-Solarzelle führen und damit zu einer geringen Ausbeute an elektrischer Energie eines entsprechenden, Perowskit-Solarzellen aufweisenden Photovoltaikmoduls.

In ein Photovoltaikmodul eindringende Feuchtigkeit führt allerdings auch bei Modulen mit konventionellen Silicium-Solarzellen in der Regel zu einer Verkürzung der Lebensdauer des Moduls. Hier ist vor allem Korrosion bei elektrisch leitenden Verbindungen stromdurchflossener Bauteile im Photovoltaikmodul die Ursache. Eine Vermeidung von Feuchtigkeit im Inneren des Moduls ist also auch bei Photovoltaikmodulen mit Silicium-Solarzellen erstrebenswert.

Aus diesen Gründen werden im Stand der Technik die Solarzellen in einem Photovoltaikmodul beispielsweise mit einer Glas-Glas-Verkapselung, die am Rand mit Polymer verklebt ist, verkapselt. Alternativ ist auch eine (oft flexibel ausgeführte) Mehrlagenverkapselung aus organischen und anorganischen Schichten möglich (z.B. eine Kombination von Nitriden und Oxiden).

Hiermit werden in der Regel befriedigende Ergebnisse erzielt und derartig verkapselte Zellen bestehen die Standardbelastungstests für Photovoltaikmodule, die unter anderem aus einer Beaufschlagung des Photovoltaikmoduls mit hoher Feuchtekonzentrationen bei erhöhten Temperaturen besteht. Nachdem jede reale Verkapselung aber eine, wenn auch geringe, Leckrate aufweist, besteht jedoch im Langzeitbetrieb eine gewisse Gefahr des langsamen Eindringens von Feuchtigkeit mit dadurch hervorgerufener Degradation der Leistung des Photovoltaikmoduls.

Alternativ oder zusätzlich können auch feuchteabsorbierende Materialien in die Verkapselung eingebracht werden. Diese erschöpfen sich jedoch aufgrund begrenzter Materialmenge langfristig, so dass auch hier langfristig (Zeithorizont 20 - 25 Jahre) mit einem Feuchteeintritt in das Photovoltaikmodul zu rechnen ist.

Die Erfinder haben sich somit die Aufgabe gestellt, ein Konzept zu entwickeln, wie das Innere eines Photovoltaikmoduls möglichst effizient und dauerhaft trocken gehalten werden kann.

### Allgemeine Beschreibung der Erfindung

Die Lösung dieser Aufgabe ist in den unabhängigen Ansprüchen offenbart, die ein Verfahren zum Entfeuchten eines Photovoltaikmoduls und ein im Vergleich zum Stand der Technik entsprechend modifiziertes Photovoltaikmodul beanspruchen. Vorteilhafte Ausführungsformen und Weiterbildungen sind in den abhängigen Ansprüchen, der Beschreibung und den Zeichnungen offenbart.

Es wird ein Photovoltaikmodul mit einer oder mehreren Solarzellen und einer Verkapselungsvorrichtung angegeben. Die Verkapselungsvorrichtung umschließt dabei die Solarzelle. Das erfindungsgemäße Photovoltaikmodul ist dadurch charakterisiert, dass es ferner eine Elektrolyseeinheit zur Entfeuchtung des Inneren der Verkapselungsvorrichtung aufweist, wobei die Elektrolyseeinheit eine Kathode, eine Anode und einen die Kathode und Anode verbindenden Ionenleiter aufweist und wobei die Elektrolyseeinheit dafür ausgestaltet ist, Wasser in Wasserstoff und Sauerstoff aufzuspalten.

Ein wichtiger Aspekt der Erfindung besteht darin, dass das Photovoltaikmodul mit der von der Verkapselungsvorrichtung umschlossenen Solarzelle eine Elektrolyseeinheit aufweist, die Wasser, das gegebenenfalls in die Verkapselung, das heißt in das Innere der Verkapselungsvorrichtung, eingetreten ist, in Wasserstoff und Sauerstoff aufspalten kann. Das "Innere der Verkapselungsvorrichtung" bezieht sich hierbei auf den Raum bzw. den Bereich zwischen der Verkapselung und der Solarzelle. Das Innere der Verkapselungsvorrichtung kann in anderen Worten auch als Hohlraum bezeichnet werden. Die Aussage, dass die Solarzelle von einer Verkapselungsvorrichtung umschlossen ist, ist also so zu verstehen, dass die Verkapselungsvorrichtung einen geschlossenen Hohlraum bildet und die Solarzelle in diesem Hohlraum angeordnet ist.

Für die Verkapselung von Solarzellen eines Photovoltaikmoduls gibt es eine Reihe von Ansätzen, von denen im Folgenden zwei Ansätze beispielhaft erwähnt werden.

Die Solarzellen werden in aller Regel zur statischen Stabilisierung auf ein Trägermaterial aufgebracht. In den meisten Fällen handelt es sich dabei um Glas, es kommen aber auch Plexiglas, Metall oder Kunststofffolien zum Einsatz. Die Solarzellen können je nach Verfahren auf, hinter oder zwischen dem Trägermaterial sitzen. Wichtig ist, dass die Abdeckung auf der lichtempfindlichen Seite der Solarzelle eine hohe Transmission aufweist, um möglichst viel der eingestrahlten Sonnenenergie auf die Solarzelle weiterzugeben.

Im ersten Ansatz, der auch als Glas/Folie-Verkapselung bezeichnet wird, werden für die Vorderseite eine gehärtete Weißglasscheibe, zur Einbettung ein vernetzender Kunststoff mit dem Namen Ethylen-Vinylacetat (EVA) und für die Rückseite ein Folienverbund verwendet. Dieser Folienverbund besteht aus drei Folien. Zwischen zwei dünnen Polyvinylfluorid-Folien (PVF, Tedlar) ist eine dickere Folie aus Polyethylenterephthalat (PET) geklebt. Dieser Folienverbund gewährleistet die elektrische Isolierung nach hinten und ist gleichzeitig sehr witterungsstabil.

Ein zweiter Ansatz besteht in der vollkommen laminatfreien Verkapselung der Solarzellen zwischen zwei Glasscheiben. Im Wesentlichen werden die Solarzellen hier ähnlich wie im Isolierglasfensterbau eingekapselt. Die beiden Glasscheiben sind am Rand möglichst hermetisch versiegelt. Hierfür kommt ein mit einem Trocknungsmittel gefülltes Butyl aus der Isolierglasindustrie oder eine Randversiegelung mittels Glaslot in Betracht. Beide Technologien haben den Vorteil, dass sich vor den Solarzellen kein Kunststoff mehr befindet, dessen Lichtdurchlässigkeit durch Sonnenlicht vermindert werden kann. Außerdem wird der etwa 20 Minuten dauernde Laminierschritt durch einen deutlich kürzeren und kostengünstigeren Press- und Randversiegelungsschritt ersetzt.

Es können also unterschiedliche Komponenten als Verkapselungsvorrichtung im Sinne der Erfindung fungieren. Sind die Solarzellen beispielsweise zwischen zwei Glasplatten angeordnet und die Seitenränder sind versiegelt, gelten die Glasplatten mit der Randversiegelung als Verkapselungsvorrichtung. Die Elektrolyseeinheit wäre dann dafür ausgestaltet, Wasser, das in den Hohlraum zwischen den Glasplatten eingetreten ist, aufzuspalten. Sind die Solarzellen beispielsweise in EVA eingebettet, kann auch das EVA als Verkapselungsvorrichtung dienen. Die Elektrolyseeinheit wäre dann dafür ausgestaltet, den Bereich zwischen dem EVA und den Solarzellen zu entfeuchten, indem sie etwaig dort vorhandenes Wasser aufspaltet. Sind die Solarzellen sowohl in einem vernetzenden Kunststoff eingebettet als auch zwischen zwei Glasscheiben mit Randversiegelung angeordnet, kann die Elektrolyseeinheit sowohl für die Entfeuchtung des Bereichs zwischen dem Kunststoff und den Solarzellen als auch für den Bereich zwischen den Glasscheiben und dem Kunststoff ausgestaltet sein.

Es wird betont, dass die vorliegende Erfindung für prinzipiell jede Art von Verkapselungsvorrichtung anwendbar ist. Die in der Beschreibung und den Ansprüchen genannten Ausführungsformen sind nur beispielhaft und sollen den Schutzbereich nicht einschränken.

Die Elektrolyseeinheit weist eine Kathode, eine Anode und einen die Kathode und Anode verbindenden Ionenleiter auf. Die Kathode und die Anode werden auch als Elektroden bezeichnet. An den beiden Elektroden liegt eine Gleichspannung an. Die Spannungsquelle bewirkt einen Elektronenmangel in der mit dem Pluspol verbundenen Elektrode, der Anode, und einen Elektronenüberschuss in der anderen, mit dem Minuspol verbundenen Elektrode, der Kathode. Der abgeschiedene, gasförmige Wasserstoff sammelt sich an der Kathode und steigt an ihr auf; der abgeschiedene, gasförmige Sauerstoff an der Anode. Das Reaktionsschema der Wasserelektrolyse lautet:

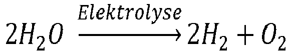

Zwischen den Elektroden befindet sich ein Ionenleiter. Der Ionenleiter wird auch als Elektrolyt bezeichnet und umfasst eine chemische Verbindung, die im festen, flüssigen oder gelösten Zustand in Ionen dissoziiert ist und die sich unter dem Einfluss eines elektrischen Feldes gerichtet bewegt.

In einer bevorzugten Ausführungsform wird für die Elektrolyseeinheit zur Entfeuchtung des Inneren der Verkapselungsvorrichtung kein flüssiger Elektrolyt, sondern ein Festkörperelektrolyt, der auch als Festelektrolyt oder Feststoffelektrolyt bezeichnet wird, verwendet. Der Grund hierfür ist, dass innerhalb der Verkapselungsvorrichtung eine Flüssigkeit in den meisten Fällen unerwünscht ist, da sie die Solarzelle schädigen kann (die Elektrolyseeinheit hat ja gerade den Zweck, das Innere der Verkapselungsvorrichtung zu entfeuchten) .

Bevorzugte Ionenleiter für die vorliegende Erfindung sind beispielsweise Proton-Austausch-Membrane (englisch: Polymer Electrolyte Membrane, PEM) oder Keramiken mit der allgemeinen Struktur **Na₁₊ₓZr₂SiₓP₃₋ₓO₁₂, 0 < x < 3** (englisch: sodium (Na) super ionic conductor, NASICON). Aber auch andere bekannte Festkörperelektrolyte wie Yttrium stabilisiertes Zirkoniumdioxid, dotiertes Lanthanfluorid oder Natrium-ß-aluminat können verwendet werden.

Nach der Aufspaltung des sich im Inneren der Verkapselungsvorrichtung befindlichen Wassers sollten der Wasserstoff und Sauerstoff das Innere der Verkapselungsvorrichtung verlassen, um nicht etwa wieder zu Wasser zu rekombinieren.

Die Wasserstoffmoleküle können aufgrund ihrer sehr geringen Größe durch die meisten Materialien problemlos hindurchdiffundieren. Die größere Herausforderung besteht demnach darin, auch die Sauerstoffmoleküle nach außen zu "transportieren". Deswegen ist in einer Ausführungsform der Erfindung zumindest die Anode außerhalb der Verkapselungsvorrichtung angeordnet, so dass der an der Anode abgeleitete Sauerstoff direkt an die Umgebung abgegeben werden kann. Weist das Material der Verkapselungsvorrichtung aber eine ausreichend hohe Durchlässigkeit auch für die Sauerstoffmoleküle auf, ist es ebenso denkbar, dass sowohl die Anode als auch die Kathode jeweils vollständig im Inneren der Verkapselungsvorrichtung angeordnet sind.

Eine weitere attraktive Ausführungsform der Erfindung besteht darin, dass der Ionenleiter selbst einen Teil der Verkapselungsvorrichtung darstellt. Der Ionenleiter ersetzt also insbesondere einen Teil der Verkapselungsvorrichtung, nämlich an der Stelle, wo er sich befindet und die Grenze zwischen dem Inneren und dem Äußeren der Verkapselungsvorrichtung darstellt.

Eine weitere attraktive Ausführungsform der Erfindung besteht darin, dass der Ionenleiter auf der Innenseite eines Teils der Verkapselungsvorrichtung angebracht ist. Somit hat der Ionenleiter eine stabile "Befestigung" und ist nahe der äußeren Umgebung angeordnet (nur getrennt durch die Verkapselungsvorrichtung selbst).

Um eine eventuelle Abschattung der Solarzelle(n) des Photovoltaikmoduls von vorneherein auszuschließen, kann die Elektrolyseeinheit in einer Ausführungsform der Erfindung gegenüber derjenigen Seite des Photovoltaikmoduls angeordnet sein, die zur Beaufschlagung des Photovoltaikmoduls mit elektromagnetischer Strahlung der Sonne vorgesehen ist. Die Elektrolyseeinheit kann sich also in anderen Worten auf der Rückseite des Photovoltaikmoduls befinden.

Alternativ kann die Elektrolyseeinheit in einer anderen Ausführungsform der Erfindung auch am bzw. im Rahmen des Photovoltaikmoduls angeordnet sein (sofern das Photovoltaikmodul einen Rahmen aufweist), um eine Abschattung der Solarzelle durch die Elektrolyseeinheit zu vermeiden. Diese Variante erscheint vor allem für diejenige Ausführungsform, in der die Anode der Elektrolyseeinheit außerhalb der Verkapselungsvorrichtung angeordnet ist, vorteilhaft, da somit kein Durchgang (bzw. Durchbruch) der Anode durch die Verkapselungsvorrichtung notwendig ist. Dies erscheint vor allem dann vorteilhaft, wenn die Verkapselungsvorrichtung im Wesentlichen aus einer Glasscheibe besteht, die andernfalls für den Durchgang für die Anode durchbrochen werden müsste.

Die vorliegende Erfindung ist im Prinzip auf jede Art von Photovoltaikmodulen anwendbar. Besonders vorteilhaft erscheint sie jedoch im Zusammenhang mit Photovoltaikmodulen mit Perowskit-Solarzellen. Dies liegt daran, dass insbesondere bei Perowskit-Solarzellen bereits geringe Mengen an Feuchtigkeit zu gravierenden Schäden an den Perowskit-Solarzellen führen können. Diese können letztendlich zu einer oftmals irreversiblen Reduzierung des Wirkungsgrads der Perowskit-Solarzelle führen und damit zu einer geringen Ausbeute an elektrischer Energie des entsprechenden, Perowskit-Solarzellen aufweisenden Photovoltaikmoduls.

Die Entfeuchtung des Inneren der Verkapselungsvorrichtung, das heißt der Betrieb der Elektrolyseeinheit, ist ein Prozess, der Energie kostet. In einer Ausführungsform der Erfindung ist das Photovoltaikmodul deswegen so ausgestaltet, dass die Elektrolyseeinheit mit der von der oder den Solarzelle(n) erzeugten elektrischen Energie direkt betrieben werden kann.

Im Übrigen kann aber angenommen werden, dass bei einer an sich funktionierenden und stabilen Verkapselung nur geringste Mengen an Wasser überhaupt in das Innere der Verkapselungsvorrichtung eindringen können. Deswegen wird die benötigte Energie für den Betrieb der Elektrolyseeinheit als gering eingeschätzt.

Neben dem Photovoltaikmodul mit der Elektrolyseeinheit ist die Erfindung auch auf ein Verfahren zur Entfeuchtung eines Photovoltaikmoduls gerichtet. Das Photovoltaikmodul umfasst mindestens eine Solarzelle, eine Verkapselungsvorrichtung und eine Elektrolyseeinheit. Die Elektrolyseeinheit ist dazu ausgestaltet, Wasser in Wasserstoff und Sauerstoff aufzuspalten. Die Solarzelle ist von der Verkapselungsvorrichtung umschlossen. Die Elektrolyseeinheit weist eine Kathode, eine Anode und einen die Kathode und Anode verbindenden Ionenleiter auf.

Das Verfahren umfasst:
- ein Anlegen einer elektrischen Spannung, insbesondere einer Gleichspannung, an die Kathode und Anode der Elektrolyseeinheit, um am Ionenleiter adsorbierte Wassermoleküle in Wasserstoff und Sauerstoff aufzuspalten,
- ein Ableiten des Wasserstoffs zur Kathode und des Sauerstoffs zur Anode, jeweils über den Ionenleiter und
- ein Trennen der Kathode und Anode von der angelegten Spannung.

In einer möglichen Variante erfolgt das Trennen von der angelegten Spannung nach einer vorbestimmten Zeitdauer nach dem Anlegen der Spannung, wobei die Zeitdauer im Bereich zwischen 2 Sekunden und 2 Minuten, insbesondere zwischen 2 Sekunden und 60 Sekunden, besonders bevorzugt zwischen 5 Sekunden und 20 Sekunden liegt.

In anderen Worten ist die Elektrolyseeinheit vorteilhafterweise nur jeweils für eine kurze Zeitdauer aktiviert. Dies reduziert den Energieverbrauch der Elektrolyseeinheit und sollte in den meisten praktischen Fällen dennoch zur Entfeuchtung des Inneren der Verkapselungsvorrichtung ausreichend sein, vor allem dann, wenn die Elektrolyseeinheit regelmäßig aktiviert wird. Beispielsweise kann es vorteilhaft sein, wenn die Elektrolyseeinheit in festgelegten Intervallen von einmal pro Woche oder einmal pro Monat betrieben wird. Die anzulegende Spannung ist insbesondere kleiner als 10 Volt. Vorteilhafterweise liegt sie im Bereich 1,2 Volt bis 5 Volt, besonders bevorzugt im Bereich 2,5 Volt bis 3 Volt.

Das erfindungsgemäße Verfahren offenbart noch einen besonderen zusätzlichen Nutzen: Durch Messung des Elektrolysestroms oder der für die Elektrolyse verwendeten Ladungsmenge kann die Menge des eingedrungenen Wassers bestimmt und damit über das Verhältnis Ladungsmenge/Intervall für den Elektrolysevorgang eine Abschätzung der Qualität der Verkapselung und deren mögliche Veränderungen vorgenommen werden. Dadurch wird eine Bewertung der Gesamtlebensdauer des Photovoltaikmoduls möglich wird.

Des Weiteren kann durch Messung des Elektrolysestroms der Prozess geregelt werden. Dafür legt man die Elektrolysespannung an und betrachtet den entstehenden Elektrolysestrom. Sobald der Elektrolysestrom abfällt oder gar nicht auftritt, ist das Wasser im Inneren der Verkapselung entfernt.

In einer vorteilhaften Ausführungsform der Erfindung wird somit nach dem Anlegen der Spannung der Elektrolysestrom ermittelt und der Zeitpunkt des Trennens von Anode und Kathode von der angelegten Spannung basierend auf dem ermittelten Elektrolysestrom gewählt.

### Kurze Beschreibung der Zeichnungen

Nachfolgend wird die Erfindung anhand der beigefügten Abbildungen veranschaulicht.

Die Abbildungen zeigen:
- Fig. 1:: eine Elektrolyseeinheit mit einem Festkörperelektrolyt als Ionenleiter,
- Fig. 2:: eine erste Ausführungsform des erfindungsgemäßen Photovoltaikmodul und
- Fig. 3:: eine zweite Ausführungsform des erfindungsgemäßen Photovoltaikmodul.

### Detaillierte Beschreibung der Zeichnungen

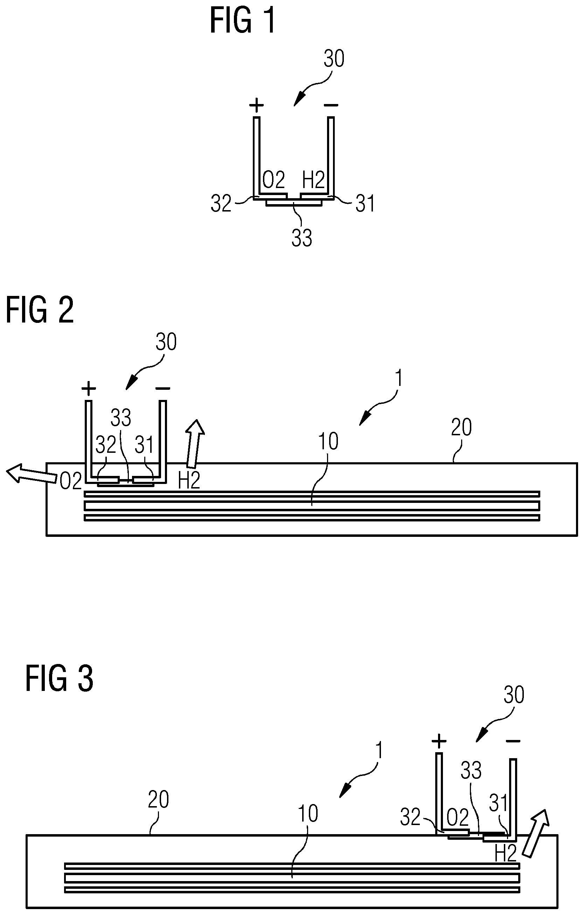

Die Abbildung 1 (auch als Fig. 1 bezeichnet) zeigt schematisch eine Elektrolyseeinheit 30. Die Elektrolyseeinheit 30 weist eine erste Elektrode auf, die als Kathode 31 fungiert, und eine zweite Elektrode, die als Anode 32 fungiert. Die beiden Elektroden 31, 32 sind mit einem Ionenleiter 33 elektrisch leitend verbunden. Der Ionenleiter 33 in dem in Abbildung 1 gezeigten Beispiel ist ein Festkörper, weswegen er, z.B. in Abgrenzung zu ansonsten üblichen flüssigen Elektrolyten, als Festkörperelektrolyt bezeichnet wird.

Bei Anlegung einer Gleichspannung im niedrigen oder mittleren einstelligen Voltbereich (z.B. zwischen 1,2 Volt und 5 Volt), werden Wassermoleküle, die auf dem Ionenleiter angelagert sind, in Wasserstoffmoleküle (H₂) und Sauerstoffmoleküle (O₂) aufgespalten. Die Wasserstoffmoleküle sind positiv geladene Ionen und migrieren deswegen zur Kathode 31, an der der Minuspol der Gleichspannung angelegt ist. Die Sauerstoffmoleküle sind negativ geladene Ionen und migrieren deswegen zur Anode 31, an der der Pluspol der Gleichspannung angelegt ist. Im Ergebnis erfolgt eine Aufspaltung und Trennung des Wassers in Wasserstoffmoleküle und Sauerstoffmoleküle.

In Abbildung 2 (auch als Fig. 2 bezeichnet) ist die in Abbildung 1 gezeigte Elektrolyseeinheit 30 so abgebildet, wie sie in ein Photovoltaikmodul 1 integriert werden kann. Das Photovoltaikmodul 1 weist eine Vielzahl von Solarzellen 10 auf, wovon der Übersicht halber in Abbildung 2 nur eine gezeigt ist. Die Solarzelle 10 ist von einer Verkapselungsvorrichtung 20 umschlossen. Es ist für die der Erfindung zugrunde liegende Idee unwesentlich, wie die Verkapselungsvorrichtung 20 konkret ausgestaltet ist (in der allgemeinen Beschreibung der Erfindung wurden beispielhaft ein paar mögliche Realisierung der Verkapselung einer Solarzelle offenbart). Die Verkapselungsvorrichtung 20 umschließt die Solarzelle 10 vollständig und schützt sie somit vor Verschmutzung, Feuchtigkeit und mechanische Einwirkungen.

In einem Bereich im Inneren der Verkapselungsvorrichtung 20 ist die Elektrolyseeinheit 30 platziert. Die Kathode 31 und die Anode 32 der Elektrolyseeinheit 30 sowie der die beiden Elektroden 31, 32 verbindende Ionenleiter 33 befinden sich vollständig im Inneren der Verkapselungsvorrichtung 20. Lediglich die elektrischen Leitungen zur Versorgung der Elektroden reichen ins Äußere der Verkapselungsvorrichtung 20. An den Durchführungen, an denen die elektrischen Leiter vom Inneren nach außen durch die Verkapselungsvorrichtung 30 (Glasscheiben, ausgehärtetes EVA,...) hindurchgeleitet werden, muss sorgfältig jegliches Eindringen von Wasser von außen verhindert werden.

Für Wassermoleküle, die, auf welche Weise auch immer, dennoch ins Innere der Verkapselungsvorrichtung 20 gelangen, ist die Elektrolyseeinheit 30 vorgesehen. Wassermoleküle, die am Ionenleiter 33 angelagert sind, werden bei angelegter Spannung aufgespalten und migrieren als gasförmige Wasserstoff- und Sauerstoffmoleküle zu Kathode bzw. Anode. In anderen Worten werden sie dorthin abgeleitet. Dort sammeln sie sich und lösen sich nach einer Weile. In der in Abbildung 2 gezeigten Ausführungsform ist die Verkapselungsvorrichtung 20 so ausgestaltet, dass sowohl die Wasserstoff- als auch die Sauerstoffmoleküle durch das Material der Verkapselungsvorrichtung 20 diffundieren können. Sie entweichen also aus dem Inneren der Verkapselungsvorrichtung 20, so dass das Innere der Verkapselungsvorrichtung 20 auf diese Weise entfeuchtet wird.

In Abbildung 3 (auch als Fig. 3 bezeichnet) ist eine leicht abgewandelte Ausführungsform des erfindungsgemäßen Photovoltaikmodul 1 gezeigt. Hier ist die Elektrolyseeinheit 30 in der Verkapselungsvorrichtung 20 integriert. Im Speziellen stellt der Ionenleiter 33, auch hier wieder ein Festkörperelektrolyt, ein Teil der Verkapselungsvorrichtung 20 dar. Umfasst die Verkapselungsvorrichtung 20 beispielsweise im Wesentlichen zwei planparallel zueinander angeordnete Glasscheiben, wäre in der einen Glasscheibe ein Bereich ausgespart, der von dem Ionenleiter 33 ausgefüllt ist. Der Vorteil hiervon ist, dass die Anode 32 außen (d.h. außerhalb des Verkapselungsvorrichtung 20) angeordnet werden kann und somit die größeren Sauerstoffmoleküle nicht durch die Verkapselungsvorrichtung 20 hindurchdiffundieren müssen, sondern direkt nach außen entweichen können.

Zusammenfassend zeigt die vorliegende Erfindung einen eleganten Weg auf, wie das Innere eines Photovoltaikmoduls möglichst effizient und dauerhaft trocken gehalten werden kann. Insbesondere für Photovoltaikmodule mit Perowskit-Solarzellen oder Tandem-Solarzellen mit einem Perowskit-Anteil hat dies eine große praktische Bedeutung.

### Bezugszeichenliste

- 1: Photovoltaikmodul
- 10: Solarzelle
- 20: Verkapselungsvorrichtung
- 30: Elektrolyseeinheit
- 31: Kathode
- 32: Anode
- 33: Ionenleiter

## Patentansprüche

1. Photovoltaikmodul (1) umfassend mindestens eine Solarzelle (10), wobei die Solarzelle (10) von einer Verkapselungsvorrichtung (20) umschlossen ist,
**dadurch gekennzeichnet, dass**
das Photovoltaikmodul (1) ferner eine Elektrolyseeinheit (30) zur Entfeuchtung des Inneren der Verkapselungsvorrichtung (20) aufweist, wobei die Elektrolyseeinheit (30) eine Kathode (31), eine Anode (32) und einen die Kathode (31) und Anode (32) verbindenden Ionenleiter (33) aufweist und wobei die Elektrolyseeinheit (30) dafür ausgestaltet ist, Wasser in Wasserstoff und Sauerstoff aufzuspalten.

2. Photovoltaikmodul (1) nach Anspruch 1,
wobei zumindest die Anode (32) außerhalb der Verkapselungsvorrichtung (20) angeordnet ist, so dass der an der Anode (32) entstehende Sauerstoff direkt an die Umgebung abgegeben werden kann.

3. Photovoltaikmodul (1) nach einem der vorhergehenden Ansprüche,
wobei der Ionenleiter (33) auf der Innenseite eines Teils der Verkapselungsvorrichtung (20) angebracht ist.

4. Photovoltaikmodul (1) nach einem der Ansprüche 1 oder 2,
wobei der Ionenleiter (33) einen Teil der Verkapselungsvorrichtung (20) darstellt.

5. Photovoltaikmodul (1) nach einem der Ansprüche 1 oder 2,
wobei sowohl die Anode (32) als auch die Kathode (31) jeweils vollständig im Inneren der Verkapselungsvorrichtung (20) angeordnet sind.

6. Photovoltaikmodul (1) nach einem der vorhergehenden Ansprüche,
wobei die Elektrolyseeinheit (30) gegenüber derjenigen Seite des Photovoltaikmoduls (1) angeordnet ist, die zur Beaufschlagung des Photovoltaikmoduls (1) mit elektromagnetischer Strahlung der Sonne vorgesehen ist.

7. Photovoltaikmodul (1) nach einem der vorhergehenden Ansprüche,
wobei die Solarzelle (10) eine Perowskit-Solarzelle ist.

8. Photovoltaikmodul (1) nach einem der vorhergehenden Ansprüche,
wobei die Verkapselungsvorrichtung (20) auf derjenigen Seite des Photovoltaikmoduls (1), die zur Beaufschlagung des Photovoltaikmoduls (1) mit elektromagnetischer Strahlung der Sonne vorgesehen ist, eine zumindest im Wellenlängenbereich der Aktivierungsenergie der Solarzelle (10) entsprechende im Wesentlichen transparente Abdeckung aufweist, insbesondere eine Glasscheibe.

9. Photovoltaikmodul (1) nach einem der vorhergehenden Ansprüche,
wobei die Verkapselungsvorrichtung (20) einen vernetzenden Kunststoff, insbesondere Ethylen-Vinylacetat, aufweist und die Solarzelle (10) in den vernetzenden Kunststoff eingebettet ist.

10. Photovoltaikmodul (1) nach einem der vorhergehenden Ansprüche,
wobei das Photovoltaikmodul (1) ferner so ausgestaltet ist, dass die Elektrolyseeinheit (30) mit der von der oder den Solarzelle(n) (10) erzeugten elektrischen Energie direkt betrieben werden kann.

11. Verfahren zur Entfeuchtung eines Photovoltaikmoduls (1), das Photovoltaikmodul (1) umfassend mindestens eine Solarzelle (10), eine Verkapselungsvorrichtung (20) und eine Elektrolyseeinheit (30), die dazu ausgestaltet ist, Wasser in Wasserstoff und Sauerstoff aufzuspalten, wobei die Solarzelle (10) von der Verkapselungsvorrichtung (20) umschlossen ist, und wobei die Elektrolyseeinheit (30) eine Kathode (31), eine Anode (32) und einen die Kathode (31) und Anode (32) verbindenden Ionenleiter (33) aufweist, das Verfahren umfassend ein
- Anlegen einer elektrischen Spannung, insbesondere einer Gleichspannung, an die Kathode (31) und Anode (32) der Elektrolyseeinheit (30), um am Ionenleiter (33) adsorbierte Wassermoleküle in Wasserstoff und Sauerstoff aufzuspalten,
- Ableiten des Wasserstoffs zur Kathode (31) und des Sauerstoffs zur Anode (32), jeweils über den Ionenleiter (33) und
- Trennen der Kathode (31) und Anode (32) von der angelegten Spannung.

12. Verfahren nach Anspruch 11,
wobei das Trennen von der angelegten Spannung nach einer vorbestimmten Zeitdauer nach dem Anlegen der Spannung erfolgt und wobei die Zeitdauer im Bereich zwischen 2 Sekunden und 2 Minuten, insbesondere zwischen 2 Sekunden und 60 Sekunden, besonders bevorzugt zwischen 5 Sekunden und 20 Sekunden liegt.

13. Verfahren nach einem der Ansprüche 11 oder 12,
wobei die angelegte Spannung kleiner als 10 Volt, insbesondere im Bereich 1,2 Volt bis 5 Volt, besonders bevorzugt im Bereich 2,5 Volt bis 3 Volt liegt.

14. Verfahren nach einem der Ansprüche 10 bis 13,
wobei das Anlegen der Spannung in festgelegten Intervallen von beispielsweise einmal pro Woche oder einmal pro Monat erfolgt.

15. Verfahren nach einem der Ansprüche 10 bis 14,
wobei nach dem Anlegen der Spannung der Elektrolysestrom ermittelt wird und der Zeitpunkt des Trennens von Kathode (31) und Anode (32) von der angelegten Spannung basierend auf dem ermittelten Elektrolysestrom gewählt wird.
